# EUROPEAN PATENT SPECIFICATION

(11) **EP 0 578 935 B1**
(45) Date of publication and mention of the grant of the patent: **16.08.2000**
(21) Application number: 93106841.5
(22) Date of filing: 27.04.1993
(51) Int. Cl.: G06F 11/20

(54) **Row redundancy circuit of a semiconductor memory device**
Zeilenredundanzschaltung eines Halbleiterspeichersgeräts
Circuit de redondance de ligne d'un dispositif de mémoire à semi-conducteur

(30) Priority: 13.07.1992 KR 1243792
(43) Date of publication of application: 19.01.1994
(73) Proprietor: SAMSUNG ELECTRONICS CO., LTD., Suwon-city, Kyungki-do 441-373 (KR)
(72) Inventor: Oh, Seung-Cheol, Jangahn-gu, Suwon-city, Kyungki-do (KR); Kim, Moon-Gone, Jangahn-gu, Suwon-city, Kyungki-do (KR)
(74) Representative: Grünecker, Kinkeldey, Stockmair & Schwanhäusser Anwaltssozietät

(56) References cited:
- EP-A- 0 465 808
- GB-A- 2 231 984
- IEEE JOURNAL OF SOLID-STATE CIRCUITS, vol. 26, no. 1, 1 January 1991, pages 12-17, XP000179338 MASASHI HORIGUCHI ET AL: "A FLEXIBLE REDUNDANCY TECHNIQUE FOR HIGH-DENSITY DRAM'S"

## Description

### BACKGROUND OF THE INVENTION

The present invention relates to a redundancy circuit of a semiconductor memory device, and more particularly to a row redundancy for repairing memory cells having row defect with spare memory cells.

It is known to public that the redundancy has been proposed to improve the yield of a semiconductor memory device. Here, the term "redundancy" refers to a process for replacing a predetermined memory cell when a defect occurs therein with redundant memory cells (i.e., commonly designated as a spare memory cell). For example, in case of a row redundancy, a row address corresponding to the memory cell with the defect is decoded to thus repair the defect of the normal submemory cell by means of the additional redundant cells. Generally, along with the achievement of high packing density in the semiconductor memory devices, the number of the memory cells constituting a single chip is increased. Further, the memory cells are included in a plurality of submemory cell arrays, respectively. Thus, the number of the submemory cell arrays in a single chip is gradually increased in the highly scaled semiconductor memory device. Usually, the redundant memory cell array is provided to each normal submemory cell array, so that, when a defective memory cell occurs in the normal submemory cell array, the defective memory cell array is repaired by means of the redundant memory cell array.

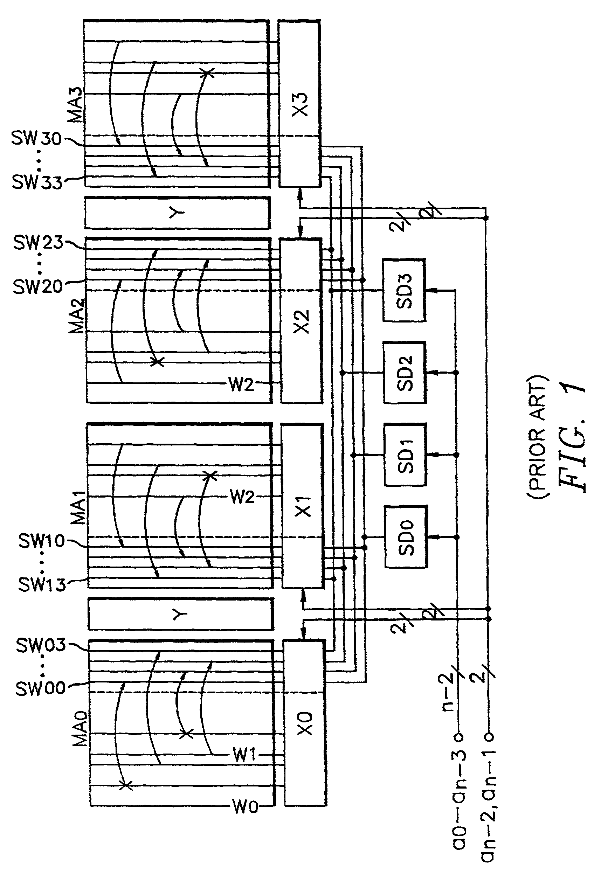

In connection with this operation, a block construction illustrating a conventional repair operation is shown in FIG 1. Here, the memory cell array within a chip is formed of four submemory cell arrays MA0, MA1, MA2 and MA3. The submemory cell array respectively have row decoders X0, X1, X2 and X3, and spare word lines, which are generally referred as redundant word lines. Also, spare decoders SD0, SD1, SD2 and SD3 are provided for driving the spare word lines during the redundancy operation. The number of the spare decoders SD0, SD1, SD2 and SD3 is the same as the number of the spare word lines of respective submemory cell arrays MA0, MA1, MA2 and MA3. The spare decoders SD0, SD1, SD2 and SD3 receive internal submemory cell array address signal a₀-aₙ₋₃ and drive the spare word lines by means of their combination. Therefore, as can be seen in this construction, if the defect occurs in the normal word line of the submemory cell array MA0 for example, the defect is programmed in the spare decoders SD0, SD1, SD2 ad SD3, and thus repaired by the spare word lines. However, as easily can be understood in the construction shown in FIG. 1, such a system is inefficient that four spare word lines are substituted for one or two defective normal word lines, i.e., the normal word lines without the defect are repaired altogether. In addition to this, it is liable to increase the possibility of the defect in the repaired spare word lines. Moreover, the spare word lines are provided for each submemory cell array by a preset number, which leads the increase of the chip area.

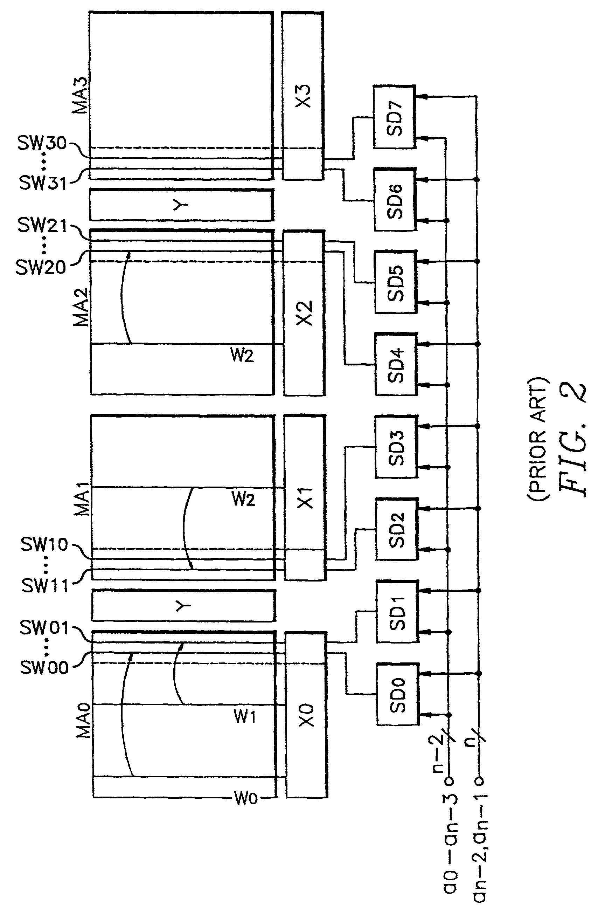

FIG. 2 shows another example illustrating a conventional redundancy suggested to solve the above-described problems. In FIG. 2, the spare word lines provided to one submemory cell array numbers less than those of FIG. 1, and a spare decoder for driving the spare word line is provided for each spare word line. Thus, as shown in the construction of FIG. 2, if one normal word line is defective, this defective word fine is repaired by only one spare word line, and two defective normal word lines are repaired by just two spare word lines. This one-tone repair method can be performed by enabling only one spare decoder which drives an optional spare word line during the redundancy operation. The system shown in FIG. 2 can solve the above-described problems of the redundancy shown in FIG. 1 in the efficiency of the redundancy, but it also has problems. In more detail, since the number of the spare word lines provided to one submemory cell array is decreased, the defect cannot be solved when the number of the defective normal word lines in a submemory cell array is greater than the number of the spare word lines provided to the submemory cell array. This also denotes that a spare word line included in a certain submemory cell array cannot replace a normal word line of a neighboring submemory cell array. Furthermore, one spare decoder must be provided per spare word line, which increases the number of the spare decoders, so that the area occupied by the spare decoders is enlarged with the consequence of being unsuitable for the high packing density.

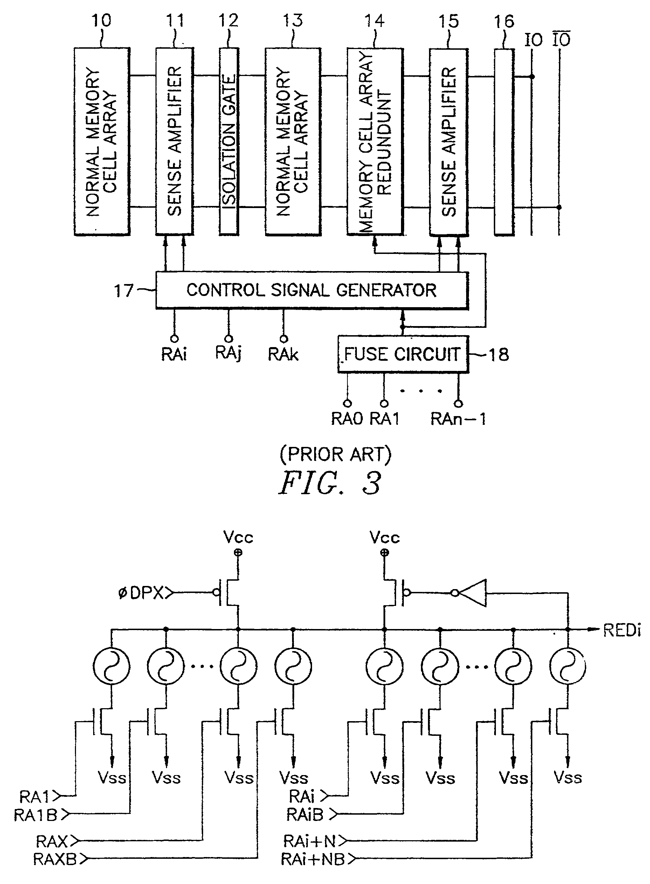

FIG. 3 shows yet another example of a conventional technique presented to solve the above-described problems. The redundancy shown in FIG. 3 has been filed by this applicant in Korean Patent Application No. 90-21502 entitled: "Redundancy circuit and Method of a Semiconductor Memory Device". The constitutional characteristics of the circuit shown in FIG. 3 is in that a redundant cell array 14 corresponds to two normal memory cell arrays 10 and 13, and an isolation gate 12 is installed between the two normal memory cell arrays 10 and 13. Then, in the redundant operation mode, a redundant sense amplifier 15 connected to one redundant memory cell array 14 is operated, so that, even if the defect occurs in either of the normal memory cell arrays 10 and 13, the defect with respect to the two memory cell arrays can be repaired by means of one redundant memory cell array 14 only. Thus, this system has effects of decreasing the size of the memory device and increasing the packing density. However, in the construction shown in FIG. 3, since the spare word line and a fuse box are dependent upon the normal memory cell arrays 13 and 14, the word-line fail only within the dependent memory cell arrays can be repaired, but cannot overcome the limitation that the word-line fail of another memory cell array cannot be repaired. Also, while the layout of the chip is improved when compared with those of FIGs. 1 and 2, due to burdensome overweight caused by the attainment of high packing density in the chip, the problem of hindering the high integration of the chip cannot be overcome. Moveover, the defect of the memory cell generated during imperfect process and the like, would not uniformly appear in the plurality of the normal memory cell arrays within the chip, which restricts the improvement of the redundancy efficiency.

### SUMMARY OF THE INVENTION

Accordingly, it is an object of the present invention to provide a semiconductor memory device having a redundant cell array suitable for enhancing high packing density in a chip.

It is another object of the present invention to provide a semiconductor memory device wherein the efficiency of the redundancy is maximized.

It is yet another object of the present invention to provide a semiconductor memory device having a redundancy circuit optimized for the layout of a chip.

It is still another object of the present invention to provide a semiconductor memory device capable of repairing word-line fails occurring in different normal memory cell arrays, using spare word lines within one redundant cell array.

It is still another object of the present invention to provide a semiconductor memory device capable of sufficiently repairing a plurality of word-line fails occurring in one normal memory cell array.

The aforementioned objects are accomplished by the present invention as set forth in the appended independent claims.

### BRIEF DESCRIPTION OF THE DRAWINGS

The above objects and other advantages of the present invention will become more apparent by describing in detail a preferred embodiment thereof with reference to the attached drawings in which:
FIG. 1 is one example showing a redundancy according to a conventional technique;
FIG. 2 is another example showing a redundancy according to a conventional technique;
FIG. 3 is still another example showing a redundancy according to a conventional technique;
FIG. 4 is a block diagram showing the construction of a redundancy according to the present invention;
FIG. 5 shows an embodiment of the fuse box shown in FIG. 4;
FIG. 6 shows an embodiment of the redundant block signal generator shown in FIG. 4;
FIG. 7 shows an embodiment of the spare word line driver shown in FIG. 4;
FIG. 8 shows an embodiment of the sense amplifier control circuit shown in FIG. 4;
FIG. 9 shows an embodiment of the normal cell array selecting circuit shown in FIG. 4;
FIGs. 10A and 10B are timing charts of respective control signals related to the present invention; and
FIGs. 11A to 11C are embodiments showing the effects of the present invention.

### DETAILED DESCRIPTION OF THE PREFERRED EMBODIMENTS

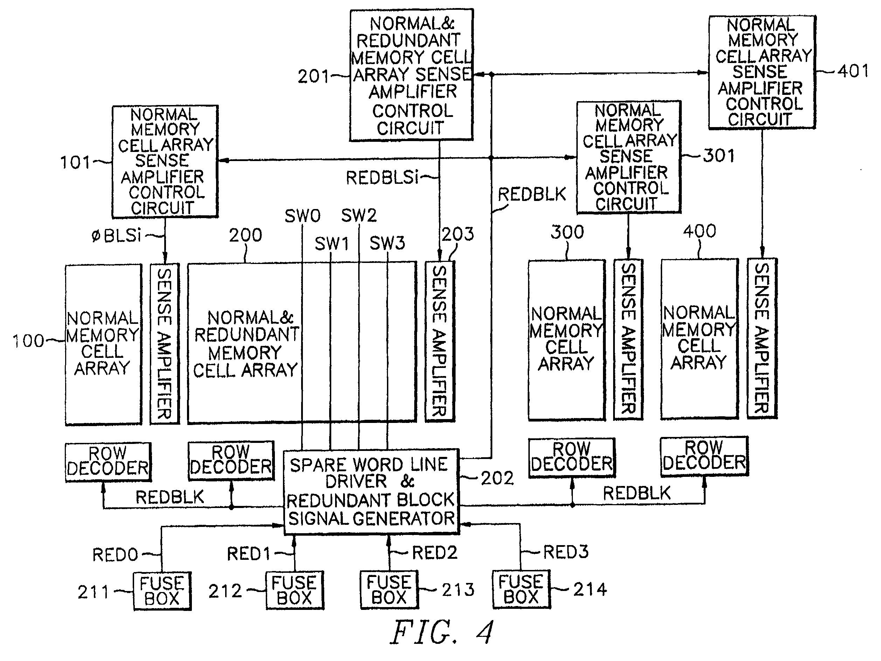

FIG. 4 is a block diagram showing a redundancy of a semiconductor memory device according to the present invention. It should be noted that the unique points of the present invention can be written as below: spare word lines are provided to an optional normal memory cell array 200 among a plurality of normal memory cell arrays which are four 100, 200, 300 and 400 in this embodiment (i.e., the normal memory cell array 200 has both a normal memory cell array and a redundant memory cell array). Accordingly, other normal memory cell arrays have no spare word line. Additionally, a number of fuse boxes are provided as long as they can be acceptable in the layout of the chip. As a result, when a word-line defect occurs in any portion of the normal memory cell arrays, the redundancy is controlled to easily repair the defect, with the spare word lines of the optional memory cell array. Hereinbelow, the characteristics of the block construction shown in FIG. 4 will be described. It is known that fuse boxes 211, 212, 213 and 214 are requisite elements for the redundancy. Different from those of the conventional technique, which have been dependent upon a specific normal memory cell array, the fuse boxes 211, 212, 213 and 214 may be arranged on a certain place considering the layout of the chip, and provided at least as many as (or less than) the number of the normal memory cell arrays. A normal & redundant memory cell array sense amplifier control circuit 201 having the spare word lines controls a sense amplifier 203 provided to the normal memory cell array 200, and allows normal operation wherein data access is carried out in the normal memory cell array to be executed during the normal operation and the redundancy to be executed upon enabling (or activation) of the redundancy. The normal & redundant memory cell array sense amplifier control circuit 201 serves as a normal/redundancy selecting circuit, and receives a row address and a selection signal of a block to be repaired (i.e., the output signal from a spare word line driver & redundant block signal generator 202 which will be described later) to thereby output a predetermined control signal REDBLSi to the sense amplifier 203. The spare word line driver & redundant block signal generator 202 is provided wherein the spare word line diver drives spare word lines SW0, SW1, SW2 and SW3 in accordance with the output signals from the fuse boxes 211, 212, 213 and 214, and the redundant block signal generator generates a signal which indicates the activation of the redundancy.

The spare word line driver and redundant block signal generator respectively receive output signals from the fuse boxes 211, 212, 213 and 214, and then, generate a predetermined signal. In FIG. 4, it should be noted that the reason of illustrating the spare word line driver and the redundant block signal generator 202 as one block is that they input the output signal RED0,..., RED3 from the fuse boxes 211, 212, 213 and 214, and function as one control circuit for enabling the redundancy operation. Normal memory cell array sense amplifier control circuits 101, 301 and 401 are provided for disabling a selected normal memory cell array when the redundancy becomes operated. The operation to make the predetermined selected normal memory cell array disable can be easily achieved by means of a predetermined selected redundant block selection signal REDBLK. Meantime, the spare word line shown in FIG. 4 numbers four (SW0, SW1, SW2 and SW3), which may be more than these in view of the layout area of the chip. The operational characteristics according to the above-described construction will be described. If a word-line fail appears in a specific normal memory cell array, as can be easily realized, the redundant cell and spare word lines are utilized so as to repair the fail. For this operation, the fuse correspond to the failed row address is cut to thereby program the failed address (such a process is disclosed in detail in Korean Patent Application Nos. 91-12919 and 90-21502 filed by this applicant). The programmed signal thus obtained is the output signal REDi (where i=0, 1, 2, 3) of the fuse boxes 211, 212, 213 and 214, and the signal REDi waits in the spare word line driver 202. Also, the signal REDi generates a signal REDBLK to disable the normal memory cell array sense amplifier control circuits 101, 301 and 401 , and the dependent row decoders and normal word lines, thereby inhibiting the normal memory cell arrays 100, 300 and 400 from operating. The signal REDBLK enables the normal & redundant memory cell array sense amplifier control circuit 201 to thus operate the redundant memory cell array 200. On the other hand, the signal REDi (where i=0, 1, 2, 3) waiting in the spare word line driver 202 drives the spare word lines upon enabling of word line basting signals which are input to the spare word line driver 202 and connected to the word lines. Since the process for enabling the spare word lines to select the redundant cell is known to public in this art, which will thus be omitted. The embodiments of the specific circuits constituting each block of FIG. 4 are as follows.

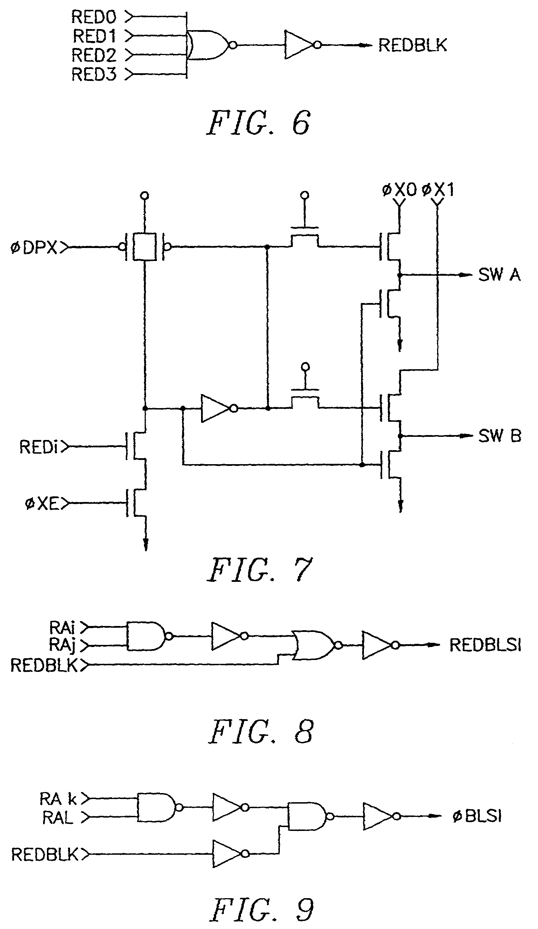

The embodiment of the fuse boxes 211, 212, 213 and 214 shown in FIG. 4 can be easily formed as shown in FIG. 5. Here, row addresses including a defective address are input, so that a fuse connected to the defective address is cut simply via a laser projection, etc., thereby producing the signal REDi.

FIG. 6 illustrates an embodiment of the redundant block signal generator of the spare word line driver & redundant block signal generating circuit 202, which receives each output signal RED0, RED1, RED2 and RED3 of the fuse boxes 211, 212, 213 and 214, thus producing the redundant block signal REDBLK.

In the construction of the spare word line driver & redundant block signal generator 202 shown in FIG. 4, an embodiment of the spare word line driver can be simply formed as shown in FIG. 7. In this construction of FIG. 7, the above-stated word line boosting signals ΦX0 and ΦX1 are instantly connected to the spare word lines.

The normal & redundant memory cell array sense amplifier control circuit 201 of FIG. 4 can be easily embodied by the construction shown in FIG. 8. The normal & redundant memory cell array sense amplifier control circuit 201 receives the row addresses and the output signal REDBLK from the redundant block signal generator 202, thereby controlling the sense amplifier 203 shown in FIG. 4.

Referring to FIG. 9, an embodiment of the normal memory cell array sense amplifier control circuits 101, 301 and 401 are illustrated. The normal memory cell array sense amplifiers control circuits 101, 301 and 401 receive the row address and the output signal REDBLK from the redundant block signal generator 202, thereby controlling the sense amplifiers dependent upon each normal memory cell array of FIG. 4.

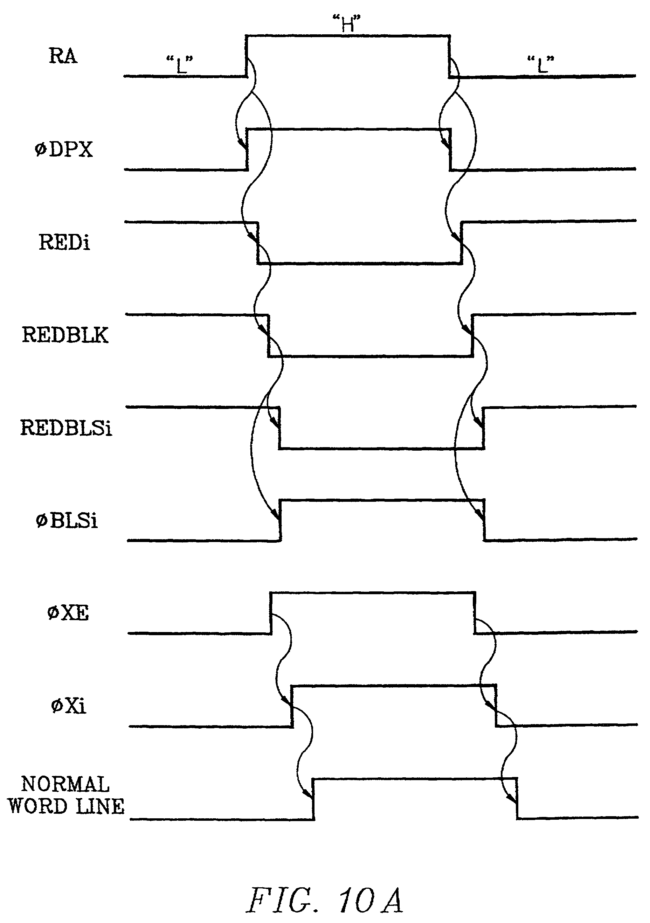

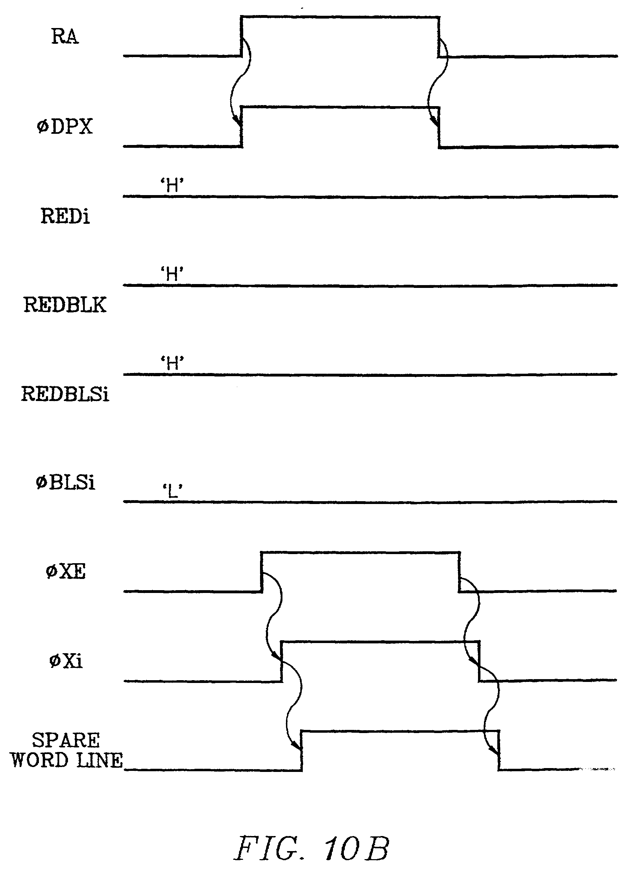

The enabling point of each signal of FIGs. 4 to 9 are illustrated in FIGs. 10A and 10B. As shown in FIG. 10A, during the normal operation, the output signal REDi of the fuse boxes 211, 212, 213 and 214 of FIG. 4 is in logic "low" level, and then the output signal REDBLK of the redundant block signal generator 202 of FIG. 6 becomes logic "low" level. By this operation, the output signal REDBLSi of the normal & redundant array sense amplifier control circuit of FIG. 8 is in logic "low" level, and the output signal ΦBLSi of the normal memory cell array sense amplifier control circuit of FIG. 9 is changed to logic "high" level. Thereafter, the word line boosting signal ΦXi is in logic "high" level to thereby select the normal word line. Meanwhile, during the redundancy operation, as shown in FIG. 10B, the output signal REDi becomes logic "high" level by the cutting operation of the fuse connected to the defective address among the fuse boxes 211, 212, 213 and 214 of FIG. 4, which makes the output signal REDBLK of the redundant block signal generator shown in FIG. 6 change to logic "high" level. Then, the output signal REDBLSi of the normal & redundant array sense amplifier control circuit shown in FIG. 8 is in logic "high" level, and the output signal ΦBLSi of the normal memory cell array sense amplifier control circuit shown in FIG. 9 is changed to logic "low" level. Finally, the spare word line is selected.

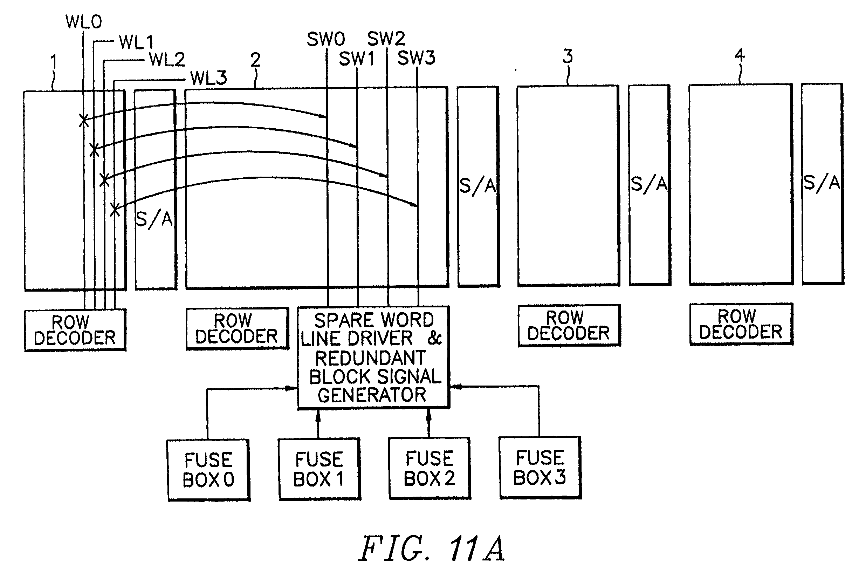

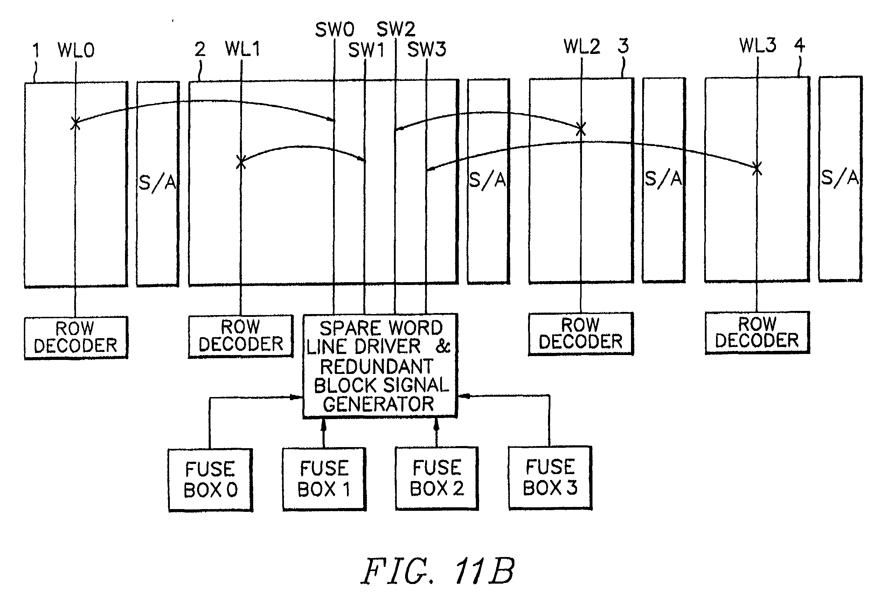

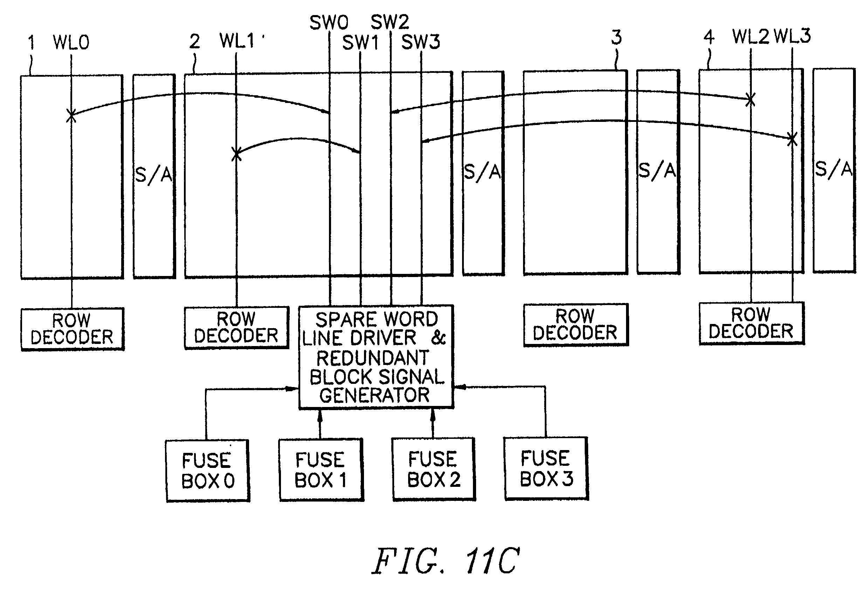

In order to assist in understanding the present invention, the block constructions of embodiments showing the effect of the present invention are illustrated in FIGs. 11A, 11B and 11C. In FIG. 11A, even if four word lines WL1, WL2, WL3 and WL4 are simultaneously failed in one normal memory cell array, the fail is programmed by the fuse boxes 1,...,3 so that the failed word lines are replaced with the spare word lines SW0, SW1, SW2 and SW3. In FIG. 11B, every word line fail in every normal memory cell array can be easily repaired. Referring to FIG. 11C, one word-line fail in a normal memory cell array 1, one in a normal memory cell array 2, no fail in a normal memory cell array 3, and two in a normal memory cell array 4 are all repaired easily by the program of the fuse boxes. As described above, all of the fuse boxes can be utilized, and provided independently of the memory cell array, resulting in improving the efficiency and yield of the redundancy.

FIG. 4 shows a block construction based on the scope of the present invention, it would be easily understood to a person having an ordinary skill in the art that the construction can be easily adopted to the conventional semiconductor memory device which requires the redundancy.

As described above, along with the trend to achieve the high packing density in a chip, the efficiency of the redundancy can be maximized while optimally applied in the chip layout. Also, the word-line fails occurring in different normal submemory cell arrays can be repaired in the word lines of one spare array. Furthermore, a plurality of word-line fails occurring in the normal cell arrays can be sufficiently repaired.

## Claims

1. A semiconductor memory device comprising:
a plurality of submemory cell arrays (100, 200, 300, 400) formed by dividing a memory cell array;
a plurality of row decoders respectively being dependent upon said plurality of submemory cell arrays (100, 200, 300, 400) for decoding a row address of each memory cell;
a plurality of sense amplifiers (203) respectively included in said plurality of submemory cell arrays (100, 200, 300, 400);
sense amplifier control circuits (101, 201, 301, 401) for operating said sense amplifiers (203);
a redundant memory array existing in any one submemory cell array (200) among said plurality of submemory cell arrays (100, 200, 300, 400);
a plurality of spare word lines (SW0 - SW3) existing in said redundant memory array for designating a memory cell of said redundant memory array;
a plurality of fuse boxes (211, 212, 213, 214) arranged independently of said plurality of submemory cell arrays (100, 200, 300, 400) for enabling the repair operation by cutting the fuse when a predetermined defective address is input; and
a control circuit (202) for receiving the output signal (RED0 - RED3) of said fuse boxes (211, 212, 213, 214), and having its output signal connect to said plurality of row decoders and sense amplifiers (203)
whereby a redundancy operation is activated in response to the programmed plurality of fuse boxes (211, 212, 213, 214) and carried out in the submemory cell array upon which said spare word lines (SW0 - SW3) are dependent.

2. A semiconductor memory device as claimed in claim 1, wherein said control circuit (202) comprises:
a spare word line driver for receiving the output signal of said fuse boxes (211, 212, 213, 214) and row addresses, and enabling said spare word lines (SW0 - SW3); and
a redundant block signal generator (202) for receiving said output signal of said fuse boxes (211, 212, 213, 214) and disabling said row decoders during said redundancy operation.

3. A semiconductor memory device as claimed in claim 2, wherein among said plurality of sense amplifier control circuits (101, 201, 301, 401) only a sense amplifier control circuit including said redundant memory array is enabled in accordance with the output signal of said redundant block signal generator (202) during said redundancy operation.

4. A semiconductor memory device comprising:
a plurality of submemory cell arrays (100, 200, 300, 400) formed by dividing a memory cell array;
a plurality of row decoders respectively being dependent upon said plurality of submemory cell arrays (100, 200, 300, 400) for decoding a row address of each memory cell;
a plurality of sense amplifiers (203) respectively included in said plurality of submemory cell arrays (100, 200, 300, 400);
a redundant memory array existing in any one submemory cell array (200) among said plurality of submemory cell arrays (100, 200, 300, 400);
a plurality of spare word lines (SW0 - SW3) existing in said redundent memory array for designating a memory cell of said redundant memory array;
a plurality of fuse boxes (211, 212, 213, 214) arranged independently of said plurality of submemory cell arrays (100, 200, 300, 400) for enabling the repair operation by cutting the fuse when a predetermined defective address is input;
a spare word line driver (202) for receiving the output signal (RED0 - RED3) of said fuse boxes (211, 212, 213, 214) and row addresses, and enabling said spare word lines (SW0 - SW3);
a redundant block signal generator (202) for receiving said output signals (RED0 - RED3) of said fuse boxes (211, 212, 213, 214) and disabling said row decoders during a redundancy operation; and
sense amplifier control circuits (101, 201, 301, 401) for receiving the output signal of said redundant block signal generator (202), and having their output signals connect to the sense amplifier (203) of said submemory cell array (200) having said redundant memory array.

5. A semiconductor memory device as claimed in claim 4, wherein the number of said word lines capable of repairing within said any one submemory cell array is determined by the number of said plurality of fuse boxes (211, 212, 213, 214).

6. A semiconductor memory device comprising;
a memory cell array consisting of a plurality of submemory cell arrays (100, 200, 300, 400) each of which has a sense amplifier (203);
a plurality of row decoders respectively being dependent upon said plurality of submemory cell arrays (100, 200, 300, 400) for decoding a row address of each memory cell;
a redundant memory array existing in any one submemory cell array (200) among said plurality of submemory cell arrays (100, 200, 300, 400);
a plurality of spare word lines (SW0 - SW3) existing in said redundant memory array for designating a memory cell of said redundant memory array;
a plurality of fuse boxes (211, 212, 213, 214) arranged independently of said plurality of submemory cell arrays (100, 200, 300, 400) for enabling the repair operation by cutting the fuse when a predetermined defective address is input;
a spare word line (202) driver for receiving the output signals (RED0 - RED3) of said fuse boxes (211, 212, 213, 214) and row addresses, and enabling said spare word lines (SW0 - SW3);
a redundant block signal generator (202) for receiving said output signals (RED0 - RED3) of said fuse boxes (211, 212, 213, 214) and disabling said row decoders during a redundancy operation; and
sense amplifier control circuits (101, 201, 301, 401) for receiving the output signal of said redundant block signal generator (202), and having their output signals connect to the sense amplifier (203) of said submemory cell array having said redundant memory array.

## Patentansprüche

1. Halbleiterspeichereinrichtung mit:
einer Vielzahl von Subspeicherzellenarrays (100, 200, 300, 400), die durch das Unterteilen eines Speicherzellenarrays gebildet sind,
einer Vielzahl von Zeilendecodern, die jeweils von der Vielzahl von Subspeicherzellenarrays (100, 200, 300, 400) abhängig sind, zum Decodieren einer Zeilenadresse von jeder Speicherzelle,
einer Vielzahl von Leseverstärkern (203), die jeweils in der Vielzahl von Subspeicherzellenarrays (100, 200, 300, 400) enthalten sind,
Leseverstärker-Steuerschaltungen (101, 201, 301, 401) zum Betreiben der Leseverstärker (203),
einem redundanten Speicherarray, das in einem beliebigen Subspeicherzellenarray (200) aus der Vielzahl von Subspeicherzellenarrays (100, 200, 300, 400) vorgesehen ist,
einer Vielzahl von Ersatzwortleitungen (SW0 - SW3) in dem redundanten Speicherarray zum Angeben einer Speicherzelle des redundanten Speicherarrays,
einer Vielzahl von Sicherungen (211, 212, 213, 214), die unabhängig von der Vielzahl von Subspeicherzellenarrays (100, 200, 300, 400) angeordnet sind, zum Aktivieren der Reparaturoperation durch das Durchtrennen der Sicherung, wenn eine vorbestimmte Defektadresse eingegeben wird, und
einer Steuerschaltung (202) zum Empfangen des Ausgabesignals (RED0 - RED3) der Sicherungen (211, 212, 213, 214) und zum Ausgeben eines Ausgabesignals an die Vielzahl von Zeilendecodern und Leseverstärkern (203),
wobei eine Redundanzoperation in Reaktion auf die programmierte Vielzahl von Sicherungen (211, 212, 213, 214) aktiviert und in dem Subspeicherzellenarray ausgeführt wird, von dem die Ersatzwortleitungen (SW0 - SW3) abhängig sind.

2. Halbleiterspeichereinrichtung nach Anspruch 1, wobei die Steuerschaltung (202) umfaßt:
eine Ersatzwortleitungssteuerung zum Empfangen des Ausgabesignals der Sicherungen (211, 212, 213, 214) und der Zeilenadressen sowie zum Aktivieren der Ersatzwortleitungen (SW0 - SW3), und
einen Redundanzblocksignalgenerator (202) zum Empfangen des Ausgabesignals der Sicherungen (211, 212, 213, 214) sowie zum Deaktivieren der Zeilendecoder während der Redundanzoperation.

3. Halbleiterspeichereinrichtung nach Anspruch 2, wobei aus der Vielzahl von Leseverstärker-Steuerschaltungen (101, 201, 301, 401) nur die eine Leseverstärker-Steuerschaltung, die das redundante Speicherarray enthält, in Übereinstimmung mit dem Ausgabesignal des Redundanzblocksignalgenerators (202) während der Redundanzoperation aktiviert wird.

4. Halbleiterspeichereinrichtung mit:
einer Vielzahl von Subspeicherzellenarrays (100, 200, 300, 400), die durch das Unterteilen eines Speicherzellenarrays gebildet sind,
einer Vielzahl von Zeilendecodern, die jeweils von der Vielzahl von Subspeicherzellenarrays (100, 200, 300, 400) abhängig sind, zum Decodieren von einer Zeilenadresse jeder Speicherzelle,
einer Vielzahl von Leseverstärkern (203), die jeweils in der Vielzahl von Subspeicherzellenarrays (100, 200, 300, 400) enthalten sind,
einem redundanten Speicherarray, das in einem beliebigen Subspeicherzellenarray (200) aus der Vielzahl von Subspeicherzellenarrays (100, 200, 300, 400) vorgesehen ist,
einer Vielzahl von Ersatzwortleitungen (SW0 - SW3) in dem redundanten Speicherarray zum Angeben einer Speicherzelle des redundanten Speicherarrays,
einer Vielzahl von Sicherungen (211, 212, 213, 214), die unabhängig von der Vielzahl von Subspeicherzellenarrays (100, 200, 300, 400) sind, zum Aktivieren der Reparaturoperation durch das Durchtrennen der Sicherung, wenn eine vorbestimmte Defektadresse eingegeben wird,
einer Ersatzwortleitungssteuerung (202) zum Empfangen des Ausgabesignals (RED0 - RED3) der Sicherungen (211, 212, 213, 214) und der Zeilenadressen sowie zum Aktivieren der Ersatzwortleitungen (SW0 - SW3),
einem Redundanzblocksignalgenerator (202) zum Empfangen der Ausgabesignale (RED0 - RED3) der Sicherungen (211, 212, 213, 214) sowie zum Deaktivieren der Zeilendecoder während einer Redundanzoperation, und
Leseverstärker-Steuerschaltungen (101, 201, 301, 401) zum Empfangen des Ausgabesignals des Redundanzblocksignalgenerators (202) und zum Ausgeben von Ausgabesignalen an den Leseverstärker (203) des Subspeicherzellenarrays (200), welches das redundante Speicherarray aufweist.

5. Halbleiterspeichereinrichtung nach Anspruch 4, wobei die Anzahl der Wortleitungen, die eine Reparatur in einem beliebigen Subspeicherzellenarray vornehmen können, durch die Anzahl der Vielzahl von Sicherungen (211, 212, 213, 214) bestimmt wird.

6. Halbleiterspeichereinrichtung mit:
einem Speicherzellenarray, das aus einer Vielzahl von Subspeicherzellenarrays (100, 200, 300, 400) besteht, von denen jedes einen Leseverstärker (203) aufweist,
einer Vielzahl von Zeilendecodern, die jeweils von der Vielzahl von Subspeicherzellenarrays (100, 200, 300, 400) abhängig sind, zum Decodieren einer Zeilenadresse von jeder Speicherzelle,
einem redundanten Speicherarray, das in einem beliebigen Subspeicherzellenarray (200) aus der Vielzahl von Subspeicherzellenarrays (100, 200, 300, 400) vorgesehen ist,
einer Vielzahl von Ersatzwortleitungen (SW0 - SW3) in dem redundanten Speicherarray zum Angeben einer Speicherzelle des redundanten Speicherarrays,
einer Vielzahl von Sicherungen (211, 212, 213, 214), die unabhängig von der Vielzahl von Subspeicherzellenarrays (100, 200, 300, 400) angeordnet sind, zum Aktivieren der Reparaturoperation durch das Durchtrennen der Sicherung, wenn eine vorbestimmte Defektadresse eingegeben wird,
einer Ersatzwortleitungssteuerung (202) zum Empfangen des Ausgabesignals (RED0 - RED3) der Sicherungen (211, 212, 213, 214) und der Zeilenadressen sowie zum Aktivieren der Ersatzwortleitungen (SW0 - SW3),
einem Redundanzblocksignalgenerator (202) zum Empfangen des Ausgabesignals (RED0 - RED3) der Sicherungen (211, 212, 213, 214) sowie zum Deaktivieren der Zeilendecoder während einer Redundanzoperation, und
Leseverstärker-Steuerschaltungen (101, 201, 301, 401) zum Empfangen des Ausgabesignals des Redundanzblocksignalgenerators (202) und zum Ausgeben von Ausgabesignalen an den Leseverstärker (203) des Subspeicherzellenarrays, welches das redundante Speicherarray aufweist.

## Revendications

1. Dispositif de mémoire à semiconducteurs comprenant :
une pluralité de sous-groupements de cellules de mémoire (100, 200, 300, 400) formés en divisant un groupement de cellules de mémoire ;
une pluralité de décodeurs de rangée dépendant respectivement de ladite pluralité de sous-groupements de cellules de mémoire (100, 200, 300, 400) pour décoder une adresse de rangée de chaque cellule de mémoire ;
une pluralité d'amplificateurs de détection (203) respectivement inclus dans ladite pluralité de sous-groupements de cellules de mémoire (100, 200, 300, 400) ;
des circuits de commande d'amplificateurs de détection (101, 201, 301, 401) pour commander lesdits amplificateurs de détection (203) ;
un groupement de mémoires redondantes existant dans l'un quelconque des sous-groupements de cellules de mémoire (200) parmi ladite pluralité de sous-groupements de cellules de mémoire (100, 200, 300, 400) ;
une pluralité de lignes de mots de réserve (SW0 à SW3) existant dans ledit groupement de mémoires redondantes pour désigner une cellule de mémoire dudit groupement de mémoires redondantes ;
une pluralité de boîtes de fusibles (211, 212, 213, 214) agencées indépendamment de ladite pluralité de sous-groupements de cellules de mémoire (100, 200, 300, 400) pour permettre l'opération de réparation en coupant le fusible lorsqu'une adresse défectueuse prédéterminée est entrée ; et
un circuit de commande (202) pour recevoir le signal de sortie (RED0 à RED3) desdites boites de fusibles (211, 212, 213, 214) et ayant son signal de sortie connecté à ladite pluralité de décodeurs de rangée et d'amplificateurs de détection (203) ;
grâce à quoi une opération de redondance est activée en réponse à la pluralité programmée de boîtes de fusibles (211, 212, 213, 214) et effectuée dans le sous-groupement de cellules de mémoire dont sont dépendantes lesdites lignes de mots de réserve (SW0 à SW3).

2. Dispositif de mémoire à semiconducteurs selon la revendication 1, dans lequel ledit circuit de commande (202) comprend :
un dispositif d'attaque de lignes de mots de réserve pour recevoir le signal de sortie desdites boîtes de fusibles (211, 212, 213, 214) et des adresses de rangées, et valider lesdites lignes de mots de réserve (SW0 à SW3) ; et
un générateur de signal de bloc redondant (202) pour recevoir ledit signal de sortie desdites boîtes de fusibles (211, 212, 213, 214) et invalider les décodeurs de rangée durant ladite opération de redondance.

3. Dispositif de mémoire à semiconducteurs selon la revendication 2, dans lequel, parmi ladite pluralité de circuits de commande d'amplificateurs de détection (101, 201, 301, 401), un seul circuit de commande d'amplificateur de détection comprenant ledit groupement de mémoires redondantes est validé en fonction du signal de sortie dudit générateur de signal de bloc redondant (202) durant ladite opération de redondance.

4. Dispositif de mémoire à semiconducteurs comprenant :
une pluralité de sous-groupements de cellules de mémoire (100, 200, 300, 400) formés en divisant un groupement de cellules de mémoire ;
une pluralité de décodeurs de rangée dépendant respectivement de ladite pluralité de sous-groupements de cellules de mémoire (100, 200, 300, 400) pour décoder une adresse de rangée de chaque cellule de mémoire ;
une pluralité d'amplificateurs de détection (203) respectivement inclus dans ladite pluralité de sous-groupements de cellules de mémoire (100, 200, 300, 400) ;
un groupement de mémoires redondantes existant dans l'un quelconque des sous-groupements de cellules de mémoire (200) parmi ladite pluralité de sous-groupements de cellules de mémoire (100, 200, 300, 400) ;
une pluralité de lignes de mots de réserve (SW0 à SW3) existant dans ledit groupement de mémoires redondantes pour désigner une cellule de mémoire dudit groupement de mémoires redondantes ;
une pluralité de boîtes de fusibles (211, 212, 213, 214) agencées indépendamment de ladite pluralité de sous-groupements de cellules de mémoire (100, 200, 300, 400) pour permettre l'opération de réparation en coupant le fusible lorsqu'une adresse défectueuse prédéterminée est entrée ;
un dispositif d'attaque de lignes de mots de réserve (202) pour recevoir le signal de sortie (RED0 à RED3) desdites boîtes de fusibles (211, 212, 213, 214) et des adresses de rangée, et valider lesdites lignes de mots de réserve (SW0 à SW3) ;
un générateur de signal de bloc redondant (202) pour recevoir lesdits signaux de sortie (RED0 à RED3) desdites boîtes de fusibles (211, 212, 213, 214) et invalider lesdits décodeurs de rangée durant une opération de redondance ; et
des circuits de commande d'amplificateurs de détection (101, 201, 301, 401) pour recevoir le signal de sortie dudit générateur de signal de bloc redondant (202), et ayant leurs signaux de sortie connectés à l'amplificateur de détection (203) dudit sous-groupement de cellules de mémoire (200) comportant ledit groupement de mémoires redondantes.

5. Dispositif de mémoire à semiconducteurs selon la revendication 4, dans lequel le nombre desdites lignes de mots susceptibles de produire une réparation à l'intérieur de l'un quelconque desdits sous-groupements de cellules de mémoire est déterminé par le nombre de ladite pluralité de boîtes de fusibles (211, 212, 213, 214).

6. Dispositif de mémoire à semiconducteurs comprenant :
un groupement de cellules de mémoire composé d'une pluralité de sous-groupements de cellules de mémoire (100, 200, 300, 400) dont chacun comporte un amplificateur de détection (203) ;
une pluralité de décodeurs de rangée dépendant respectivement de ladite pluralité de sous-groupements de cellules de mémoire (100, 200, 300, 400) pour décoder une adresse de rangée de chaque cellule de mémoire ;
un groupement de mémoires redondantes existant dans l'un quelconque des sous-groupements de cellules de mémoire (200) parmi ladite pluralité de sous-groupements de cellules de mémoire (100, 200, 300, 400) ;
une pluralité de lignes de mots de réserve (SW0 à SW3) existant dans ledit groupement de mémoires redondantes pour désigner une cellule de mémoire dudit groupement de mémoires redondantes ;
une pluralité de boîtes de fusibles (211, 212, 213, 214) agencées indépendamment de ladite pluralité de sous-groupements de cellules de mémoire (100, 200, 300, 400) pour permettre l'opération de réparation en coupant le fusible lorsqu'une adresse défectueuse prédéterminée est entrée ;
un dispositif d'attaque de lignes de mots de réserve (202) pour recevoir les signaux de sortie (RED0 à RED3) desdites boîtes de fusibles (211, 212, 213, 214) et des adresses de rangée, et valider lesdites lignes de mots de réserve (SW0 à SW3);
un générateur de signal de bloc redondant (202) pour recevoir lesdits signaux de sortie (RED0 à RED3) desdites boîtes de fusibles (211, 212, 213, 214) et invalider lesdits décodeurs de rangée durant une opération de redondance ; et
des circuits de commande d'amplificateurs de détection (101, 201, 301, 401) pour recevoir le signal de sortie dudit générateur de signal de bloc redondant (202), et ayant leurs signaux de sortie connectés à l'amplificateur de détection (203) dudit sous-groupement de cellules de mémoire comportant ledit groupement de mémoires redondantes.
